(19) Europäisches Patentamt
European Patent Office
Office européen des brevets

(11) **EP 3 868 705 A1**

(12) **EUROPEAN PATENT APPLICATION**

(43) Date of publication:
25.08.2021 Bulletin 2021/34

(51) Int Cl.:
**B81B 3/00** (2006.01)      **G01N 15/10** (2006.01)
**G01N 29/02** (2006.01)

(21) Application number: 21155639.4

(22) Date of filing: 05.02.2021

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 19.02.2020   US 202062978634 P

(71) Applicant: TDK Corporation
Tokyo 103-6128 (JP)

(72) Inventor: Sethi, Rakesh
San Jose, CA 95110 (US)

(74) Representative: Ostertag & Partner Patentanwälte
mbB
Azenbergstraße 35
70174 Stuttgart (DE)

(54) **METHODS AND DEVICES FOR DETECTING PARTICLES USING A CANTILEVER SENSOR**

(57)   Methods and devices for detecting particles are described. A sensor assembly mountable adjacent to a wheel includes a device with one or more cantilevers and a casing that at least partially encloses the one or more cantilevers. One or more through-holes are defined in the casing. The sensor assembly also includes an electrical circuit coupled with a respective cantilever of the one or more cantilevers to measure electrical signals from the respective cantilever.

Figure 1

**Description**

RELATED APPLICATIONS

This application the benefit of, and priority to, U.S. Provisional Patent Application Serial No. 62/978,634, filed February 19, 2020, which is incorporated by reference herein in its entirety.

TECHNICAL FIELD

This application relates generally to electromechanical sensors, and more particularly to electromechanical sensors that detect particles.

BACKGROUND

There have been long-standing interests in monitoring airborne particles. Airborne particles from exhaust sources (e.g., combustion engines) have been extensively studied. In recent years, there are increased interests in detecting particles from non-exhaust sources. For example, automobiles generate particles from non-exhaust sources, such as tire wear particles, road wear particles, and brake wear particles, etc.

However, detecting particles from non-exhaust sources is challenging, partly due to the difficulty in sampling and transporting the particles for laboratory analysis.

SUMMARY

The devices and methods described herein address challenges associated with conventional devices and methods for detecting airborne particles. The disclosed devices allow direct mounting on a vehicle near a particle source (e.g., tires or brakes), which eliminates the need for sampling and transporting the particles to a remote location for laboratory analysis and allows real-time (on-road) measurements even when the vehicle is operating.

In accordance with some embodiments, a sensor assembly mountable adjacent to a wheel includes a device that includes one or more cantilevers and a casing that at least partially encloses the one or more cantilevers. One or more through-holes are defined in the casing. The sensor assembly also includes a first electrical circuit coupled with a respective cantilever of the one or more cantilevers to measure electrical signals from the respective cantilever. In some embodiments, the first electrical circuit measures a resonance frequency of the respective cantilever. In some embodiments, the first electrical circuit measures a peak-to-peak voltage from the respective cantilever. In some embodiments, the one or more cantilevers include a piezoelectric material.

In accordance with some embodiments, a device includes one or more cantilevers and a casing that at least partially encloses the one or more cantilevers. One or more through-holes are defined in the casing. In some embodiments, the one or more cantilevers include a piezoelectric material,

In accordance with some embodiments, a method for detecting particles includes exposing any device described herein to airborne particles and measuring electrical signals from a respective cantilever of the one or more cantilevers.

BRIEF DESCRIPTION OF THE DRAWINGS

The disclosed devices and methods allow direct mounting on a vehicle, which allows on-road measurements even when the vehicle is operating and eliminates the need for sampling and transporting the particles to a remote location for laboratory analysis.

For a better understanding of the various described embodiments, reference should be made to the Description of Embodiments below, in conjunction with the following drawings in which like reference numerals refer to corresponding parts throughout the figures.

Figure 1 is a schematic diagram illustrating a cantilever device in accordance with some embodiments.

Figure 2A is a schematic diagram illustrating a shift in a frequency response curve in accordance with some embodiments.

Figure 2B illustrates an example curve showing a quantity of particles as a function of a resonance frequency in accordance with some embodiments.

Figure 2C illustrates an example size distribution of particles in accordance with some embodiments.

Figure 2D illustrates an example curve showing a quantity of particles as a function of a peak-to-peak voltage in accordance with some embodiments.

Figure 2E illustrates an example correction curve showing a relationship between a peak-to-peak voltage from a cantilever and a temperature in accordance with some embodiments.

Figures 3A and 3B are schematic diagrams illustrating a sensor device in accordance with some embodiments.

Figures 4A-4C are schematic diagrams illustrating a casing in accordance with some embodiments.

Figure 5A is a schematic diagram illustrating a plurality of cantilevers in accordance with some embodiments.

Figures 5B-5D illustrate a sensor device with a plurality of cantilevers in accordance with some embodiments.

Figure 6 is a schematic diagram illustrating parts of an automobile in accordance with some embodiments.

Figures 7A-7D illustrate mounting locations and orientations of a sensor device in accordance with some embodiments.

Figures 8A-8C illustrate structures of example cantilevers in accordance with some embodiments.

Figure 9 is a schematic diagram illustrating an electrical circuit for measuring a frequency in accordance with some embodiments.

Figure 10 is a flow diagram illustrating a method of detecting particles in accordance with some embodiments.

DESCRIPTION OF EMBODIMENTS

Reference will be made to embodiments, examples of which are illustrated in the accompanying drawings. In the following description, numerous specific details are set forth in order to provide a thorough understanding of the various described embodiments. However, it will be apparent to one of ordinary skill in the art that the various described embodiments may be practiced without these particular details. In other instances, methods, procedures, components, circuits, and networks that are well-known to those of ordinary skill in the art are not described in detail so as not to unnecessarily obscure aspects of the embodiments.

It will be understood that, although the terms first, second, etc. may be used herein to describe various elements, these elements should not be limited by these terms. These terms are only used to distinguish one element from another. For example, a first cantilever could be termed a second cantilever, and, similarly, a second cantilever could be termed a first cantilever, without departing from the scope of the various described embodiments. The first cantilever and the second cantilever are both cantilevers, but they are not the same cantilever.

The terminology used in the description of the embodiments herein is for the purpose of describing particular embodiments only and is not intended to be limiting of the scope of claims. As used in the description and the appended claims, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

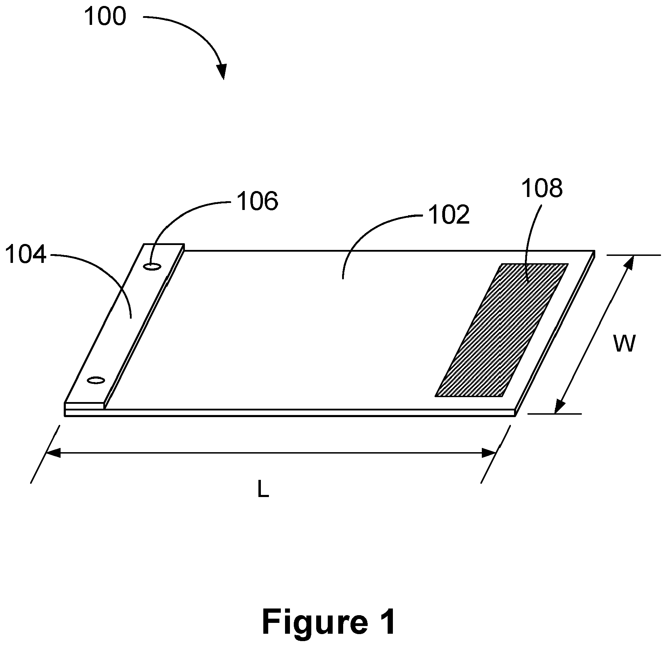

Figure 1 is a schematic diagram illustrating a cantilever device 100 in accordance with some embodiments.

A cantilever device 100 includes a cantilever 102, which is a projecting beam supported by one end. The cantilever 102 is characterized by its length L, width W, and thickness. In some embodiments, the cantilever 102 has a uniform width and a uniform thickness along its length, as shown in Figure 1. In some embodiments, the cantilever 102 has (1) a non-uniform width along its length while its thickness remains uniform along its length, (2) a non-uniform thickness along its length while its width remains uniform along its length, or (3) a non-uniform width and a non-uniform thickness along its length.

Figure 1 also shows a clamp 104 that is configured to support and immobilize one end of the cantilever 102. In Figure 1, the clamp 104 has a shape of a plate. However, a clamp having any other shape may be used. Although Figure 1 shows that the clamp 104 is located at the tip of the cantilever 102, the clamp 104 does not need to be aligned with a tip of the cantilever 102. For example, the clamp 104 may be positioned offset from the tip of the cantilever 102 (e.g., by 1 mm, 2 mm, 3 mm, 4 mm, 5 mm, 7 mm, 10 mm, 15 mm, 20 mm, 25 mm, etc.) so that there is an overhang when the clamp 104 is positioned on the cantilever 102. In some embodiments, the clamp 104 and/or the cantilever 102 have one or more through-holes 106 for securing the cantilever 102 and the clamp to a base. For example, screws may be placed through corresponding through-holes for immobilizing the clamp 104 and the cantilever 102. Alternatively, other mechanisms may be used for immobilizing the cantilever 102. For example, the clamp 104 and the cantilever 102 may have slits through which a clip is inserted to immobilize the clamp 104 and the cantilever 102. In another example, the cantilever 102 may be integrated with its base, in which case the clamp 104 is omitted.

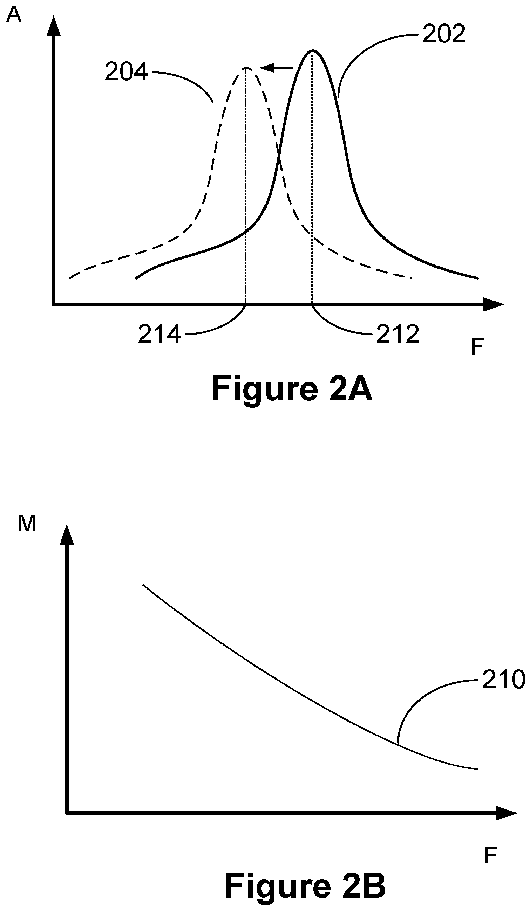

A natural frequency (also called resonance frequency or eigenfrequency) is a frequency at which a mechanical system oscillates (or resonates) in the absence of any driving or damping force. A frequency response curve 202 shown in Figure 2A represents an amplitude of a displacement in a mechanical system (e.g., a bending of the cantilever 102 in the cantilever device 100) as a function of a frequency. Frequency 212 at which the frequency response curve 202 has the maximum amplitude corresponds to the natural frequency.

For a cantilever having a uniform shape (e.g., a uniform width and a uniform thickness along its length), the natural frequency of the cantilever $f_n$ is defined as follows:

$$f_n = \frac{K_n}{2\pi} \sqrt{\frac{EIg}{wl^4}}$$

where $E$ is the modulus of elasticity, $I$ is the area moment of inertia, $g$ is the gravitational constant, $w$ is the uniform load per unit length, $l$ is the length of the cantilever, and $K_n$ is a constant that is specific to the mode of vibration. For example, $K_n$ is 3.52 for the first mode, 22.0 for the second mode, 61.7 for the third mode, 121 for the fourth mode, and 200 for the fifth mode.

When particles are adsorbed on the cantilever 102, $w$ changes (e.g., increases), which, in turn, changes (e.g., decreases) the natural frequency $f_n$. As shown in Figure 2A, as particles are adsorbed on the cantilever 102, the frequency response curve for the cantilever 102 shifts to match a frequency response curve 204 with the resonance frequency at frequency 214. In addition, the resonance frequency of the cantilever 102 shifts more with an increased amount of particles adsorbed on the cantilever 102. Thus, the quantity of the adsorbed particles can be determined by monitoring changes to the natural frequency $f_n$ of the cantilever device 100. Figure 2B illustrates an example curve 210 showing a quantity of particles as a function of a resonance frequency in accordance with some embodiments, and the curve 210 or a corresponding numerical table may be used to determine a quantity of particles based on the resonance frequency of the cantilever 102.

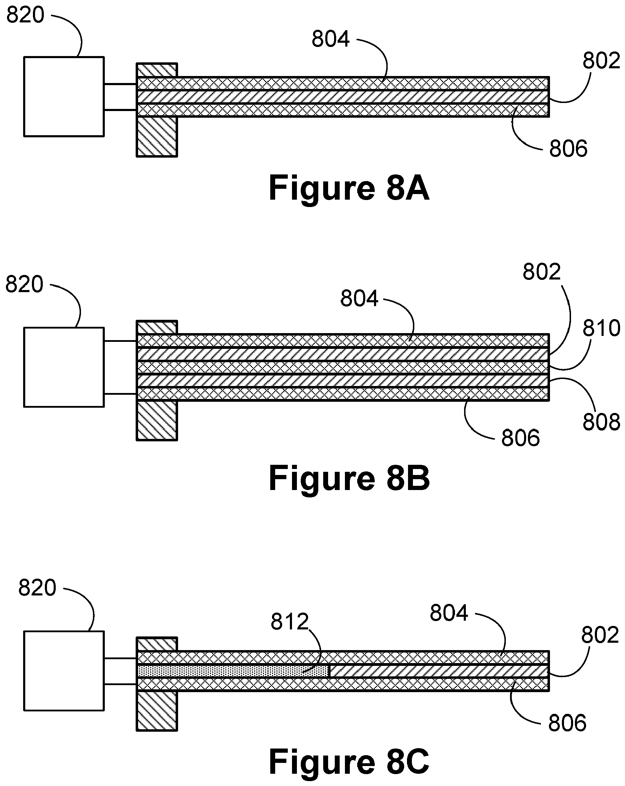

The vibration (and the resonance frequency) of the cantilever 102 may be measured using optical signals (e.g., using laser reflection), mechanical signals, and/or electrical signals. In some embodiments, the cantilever 102 includes one or more layers including a piezoelectric material (e.g., as described with respect to Figures 8A-8C). Examples of piezoelectric materials include gallium nitride, indium nitride, aluminum nitride, zinc oxide, barium titanate, lead zirconate titanate, potassium niobate, sodium tungstate, $Ba_2NaNb_5O_5$, $Pb_2KNb_5O_5$, single crystalline zinc oxide, langasite, gallium orthophosphate, lithium niobate, lithium tantalite, sodium potassium niobate, bismuth ferrite, sodium niobate, bismuth titanate, sodium bismuth titanate, quartz, berlinite, topaz, lead titanate, and piezoelectric polymers, such as polyvinylidene fluoride, polyamides, paralyne-C, polyimide, and polyvinylidene chloride. Piezoelectric materials are capable of generating electrical charge in response to applied mechanical stress. Thus, when the cantilever 102 bends, the piezoelectric material provides charges that are indicative of the amplitude of how much the cantilever 102 is bent (e.g., a displacement of a free end of the cantilever 102). Similarly, when the cantilever 102 vibrates, the piezoelectric material in the cantilever 102 provides an (oscillating) electrical signal that corresponds to the vibration of the cantilever 102. Therefore, the resonance frequency (or the natural frequency) of the cantilever 102 can be determined by measuring the frequency of the electrical signal.

The length, width, and thickness of the cantilever 102 are selected to obtain a desired performance of the cantilever device 100. In some embodiments, the length is between 1 cm and 30 cm, between 1 cm and 10 cm, between 5 cm and 15 cm, between 10 cm and 20 cm, between 15 cm and 25 cm, between 20 cm and 30 cm, between 1 cm and 5 cm, between 5 cm and 10 cm, between 10 cm and 15 cm, between 15 cm and 20 cm, between 20 cm and 25 cm, between 25 cm and 30 cm, between 1 cm and 3 cm, between 2 cm and 4 cm, between 3 cm and 5 cm, between 4 cm and 6 cm, between 5 cm and 7 cm, between 6 cm and 8 cm, between 7 cm and 9 cm, or between 8 cm and 10 cm. In some embodiments, the length is approximately 1 cm, approximately 2 cm, approximately 3 cm, approximately 4 cm, approximately 5 cm, approximately 6 cm, approximately 7 cm, approximately 8 cm, approximately 9 cm, approximately 10 cm, approximately 15 cm, approximately 20 cm, approximately 25 cm, or approximately 30 cm. In some embodiments, the width is between 1 cm and 10 cm, between 5 cm and 15 cm, between 10 cm and 20 cm, between 1 cm and 5 cm, between 5 cm and 10 cm, between 10 cm and 15 cm, between 15 cm and 20 cm, between 1 cm and 4 cm, between 2 cm and 5 cm, between 3 cm and 6 cm, between 4 cm and 7 cm, between 5 cm and 8 cm, between 6 cm and 9 cm, or between 7 cm and 10 cm. In some embodiments, the width is approximately 1 cm, approximately 2 cm, approximately 3 cm, approximately 4 cm, approximately 5 cm, approximately 6 cm, approximately 7 cm, approximately 8 cm, approximately 9 cm, approximately 10 cm, approximately 15 cm, or approximately 20 cm. In some embodiments, the thickness of the cantilever 102 is between 100 $\mu$m and 5 mm, between 100 $\mu$m and 3 mm, between 1 mm and 4 mm, between 2 mm and 5 mm, between 100 $\mu$m and 1 mm, between 500 $\mu$m and 1.5 mm, between 1 mm and 2 mm, between 1.5 mm and 2.5 mm, between 2 mm and 3 mm, between 2.5 mm and 3.5 mm, between 3 mm and 4 mm, between 3.5 mm and 4.5 mm, between 4 mm and 5 mm, between 100 $\mu$m and 500 $\mu$m, between 500 $\mu$m and 1 mm, between 1 mm and 1.5 mm, between 1.5 mm and 2 mm, between 2 mm and 2.5 mm, or between 2.5 mm and 3 mm. In some embodiments, the thickness of the cantilever 102 is approximately 100 $\mu$m, approximately 200 $\mu$m, approximately 300 $\mu$m, approximately 400 $\mu$m, approximately 500 $\mu$m, approximately 600 $\mu$m, approximately 1 mm, approximately 2 mm, approximately 3 mm, approximately 4 mm, or approximately 5 mm. In some embodiments, the thickness of a layer of the piezoelectric material in the cantilever 102 is between 10 $\mu$m and 1 mm, between 100 $\mu$m and 500 $\mu$m, between 200 $\mu$m and 600 $\mu$m, between 300 $\mu$m and 700 $\mu$m, between 400 $\mu$m and 800 $\mu$m, between 500 $\mu$m and 900 $\mu$m, between 600 $\mu$m and 1 mm, between 50 $\mu$m and 150 $\mu$m, between 100 $\mu$m and 200 $\mu$m, between 150 $\mu$m and 250 $\mu$m, between 200 $\mu$m and 300 $\mu$m, between 250 $\mu$m and 350 $\mu$m mm, between 300 $\mu$m and 400 $\mu$m, between 350 $\mu$m and 450 $\mu$m, between 400 $\mu$m and 500 $\mu$m, between 500 $\mu$m and 600 $\mu$m, between 600 $\mu$m and 700 $\mu$m, between 700 $\mu$m and 800 $\mu$m, or between 800 $\mu$m and 900 $\mu$m. In some embodiments, the thickness of the layer of the piezoelectric material in the cantilever 102 is approximately 100 $\mu$m, approximately 200 $\mu$m, approximately 300 $\mu$m, approximately 400 $\mu$m, approximately 500 $\mu$m, approximately 600 $\mu$m, approximately 700 $\mu$m, approximately 800 $\mu$m, approximately 900 $\mu$m, approximately 1 mm, approximately 2 mm, approximately 3 mm, approximately 4 mm, or approximately 5 mm.

Turning back to Figure 1, in some embodiments, one or more portions 108 of the cantilever 102 are chemically or physically processed to facilitate adsorption of particles. For example, a coating may be placed on the one or more portions 108 of the cantilever. The coating may include acrylic, urethane, silicone, or epoxy. In some embodiments, the coating covers entire top and bottom surfaces of the cantilever 102. In some embodiments, the coating covers an entire single surface (e.g., either the top surface or the bottom surface) of the cantilever 102. In some embodiments, the coating covers only a portion, less than all, of a single surface. In some embodiments, the coating covers only a portion, less than all, of the top surface and only a portion, less than all, of the bottom surface. In some embodiments, at least one coated portion is located adjacent to the free end of the cantilever 102. In some embodiments, at least one coated portion is located away from the free end of the cantilever 102 (e.g., away from the free end tip of the cantilever 102 by at least 5 mm, 6 mm, 7 mm, 8 mm, 9 mm, 10 mm, 15 mm, 20 mm, 25 mm, etc.). In some embodiments, all of the portions are covered with a same type of coating. In some embodiments, respective portions are covered with different types of coating. In some embodiments, multiple layers of coatings are over a particular region of the cantilever 102.

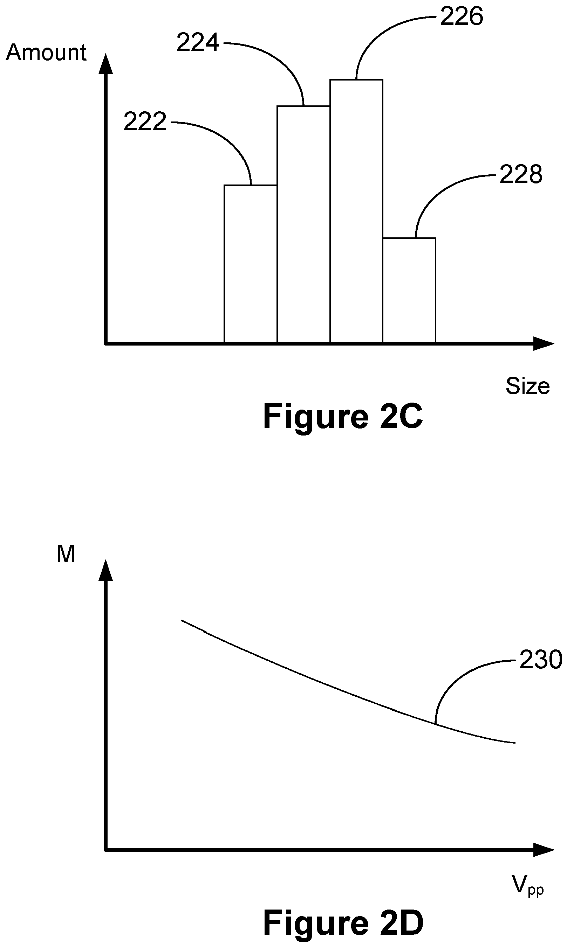

Figure 2C illustrates an example size distribution of particles in accordance with some embodiments. In some embodiments, a plurality of cantilevers is used to detect a size distribution of particles. For example, the plurality of cantilevers may include a first cantilever configured to measure a quantity of a particles having a first size range based on a resonant frequency of the first cantilever (e.g., the first cantilever is located in a chamber with through-holes configured to allow particles of the first size range to pass), a second cantilever configured to measure a quantity of a particles having a second size range based on a resonant frequency of the second cantilever (e.g., the second cantilever is located in a chamber with through-holes configured to allow particles of the second size range to pass), a third cantilever configured to measure a quantity of a particles having a third size range based on a resonant frequency of the third cantilever (e.g., the third cantilever is located in a chamber with through-holes configured to allow particles of the third size range to pass), and a fourth cantilever configured to measure a quantity of a particles having a fourth size range based on a resonant frequency of the fourth cantilever (e.g., the fourth cantilever is located in a chamber with through-holes configured to allow particles of the fourth size range to pass). In some embodiments, the first size range, the second size range, the third size range, and the fourth size range are different from one another. In some embodiments, the first size range, the second size range, the third size range, and the fourth size range do not at least partially overlap with one another (e.g., no two size ranges have any partial overlap). In some embodiments, the first size range, the second size range, the third size range, and the fourth size range may have a partial overlap. The quantity 222 measured by the first cantilever, the quantity 224 measured by the second cantilever, the quantity 226 measured by the third cantilever, and the quantity 228 measured by the fourth cantilever collectively represent a size distribution of particles.

As described with respect to Figure 2B, the resonance frequency of a cantilever is measured and used to determine a quantity of particles adsorbed on the cantilever. In some other configurations, the resonance frequency of the cantilever is measured indirectly (e.g., by measuring signals that are associated with the resonance frequency). In some configurations, some other signals may be used to determine the quantity of particles adsorbed on the cantilever. For example, a peak-to-peak voltage from a cantilever may be used to determine the quantity of particles adsorbed on the cantilever. Figure 2D illustrates an example curve 230 showing a quantity of particles as a function of a peak-to-peak voltage in accordance with some embodiments, and the curve 230 or a corresponding numerical table may be used to determine a quantity of particles based on the peak-to-peak voltage from the cantilever 102. In some configurations, a change in the peak-to-peak voltage is associated with a shift in the resonance frequency caused by adsorption of particles on the cantilever.

In some configurations, the resonance frequency of the cantilever or the peak-to-peak voltage from the cantilever changes as a function of a temperature of the cantilever (which can be determined from the temperature around the cantilever), even when there is no change in the quantity of particles adsorbed on the cantilever. In configurations where the cantilever is located in an environment with a large temperature fluctuation (e.g., adjacent to a wheel of an automobile), the large temperature fluctuation can contribute to variation in the signals from the cantilever, such as the measured resonance frequency or the peak-to-peak voltage. Thus, in some embodiments, temperature information associated with the cantilever is used to determine the quantity of particles adsorbed on the cantilever (together with the electrical signals from the cantilever) or adjust the electrical signals from the cantilever. For example, self-healing circuit (e.g., signal correction circuit) or one or more processors may be used to adjust the electrical signals from the cantilever. A self-healing operation (e.g., correction operation) may be described using the following expression, in some embodiments:

$$V_{pp,corr} = V_{pp,uncorr} - V_{correction}(T)$$

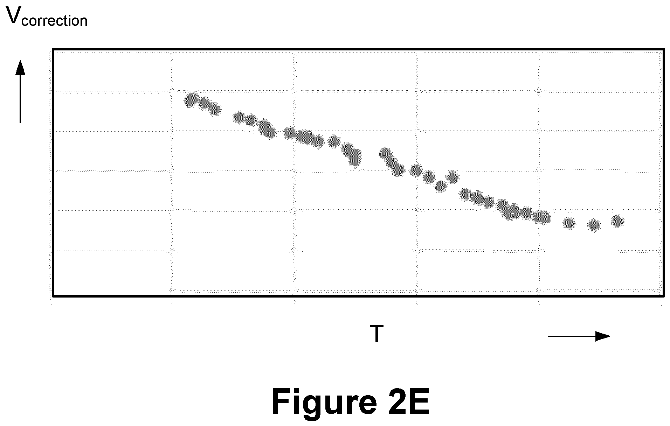

where $V_{pp,corr}$ is the corrected peak-to-peak voltage, $V_{pp,uncorr}$ is the uncorrected peak-to-peak voltage, and $V_{correction}(T)$ is a correction factor that is a function of the temperature T. In some configurations, $V_{correction}(T)$ corresponds to a correction curve shown in Figure 2E. Such correction or adjustment based on temperature allows a more accurate determination of the quantity of particles adsorbed on the cantilever.

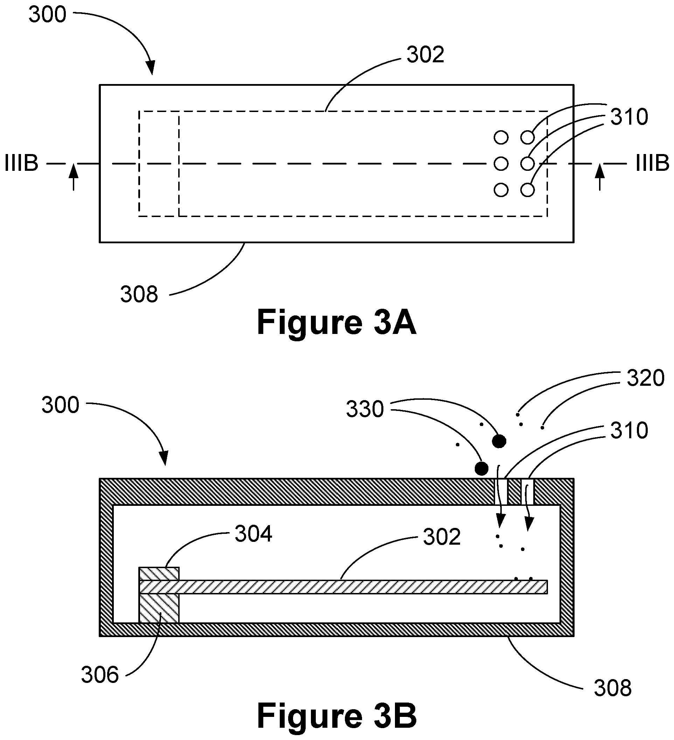

Figures 3A and 3B are schematic diagrams illustrating a sensor device 300 in accordance with some embodiments. Figure 3A is a plan view with line IIIB-IIIB, which represents the view from which the cross-sectional view shown in Figure 3B is taken.

The sensor device 300 shown in Figures 3A and 3B includes a casing 308, which encloses a cantilever 302 corresponding to the cantilever 102 described above. Figure 3A also illustrates that one or more through-holes 310 are defined in the casing 308. The one or more through-holes 310 are sized (e.g., to have a particular diameter and a depth) to facilitate particles of certain sizes (e.g., particles 320) to pass through the one or more through-holes 310 while preventing or reducing passing of particles of other sizes (e.g., particles 330) through the one or more through-holes 310. In some embodiments, a through-hole 310 has a diameter between 1 μm and 1 mm, between 1 μm and 100 μm, between 50 μm and 150 μm, between 100 μm and 200 μm, between 150 μm and 250 μm, between 200 μm and 300 μm, between 250 μm and 350 μm, between 300 μm and 400 μm, between 350 μm and 450 μm, between 400 μm and 500 μm, between 450 μm and 550 μm, between 500 μm and 600 μm, between 550 μm and 650 μm, between 600 μm and 700 μm, between 650 μm and 750 μm, between 700 μm and 800 μm, between 750 μm and 850 μm, between 800 μm and 900 μm, between 850 μm and 950 μm, between 900 μm and 1000 μm, between 1 μm and 50 μm, between 10 μm and 60 μm, between 20 μm and 70 μm, between 30 μm and 80 μm, between 40 μm and 90 μm, between 90 μm and 100 μm, between 1 μm and 20 μm, between 10 μm and 30 μm, between 20 μm and 40 μm, or between 30 |im and 50 μm. In some embodiments, the diameter of the through-hole 310 is approximately 1 μηι, approximately 2 μηι, approximately 3 μηι, approximately 4 μm, approximately 5 μm, approximately 6 μm, approximately 7 μm, approximately 8 μηι, approximately 9 μm, approximately 10 μm, approximately 20 μm, approximately 30 μm, approximately 40 μm, approximately 50 μm, approximately 60 μm, approximately 70 μm, approximately 80 μm, approximately 90 μm, approximately 100 μm, approximately 200 μm, approximately 300 μm, approximately 400 μm, approximately 500 μm, approximately 600 μm, approximately 700 μm, approximately 800 μm, approximately 900 μm, or approximately 1 mm. In some embodiments, a mesh is positioned adjacent to a through-hole 310 so that the mesh further limits the size of particles that enter the casing 308. In some embodiments, a through-hole 310 has a depth between 1 μm and 1 mm, between 1 μm and 100 μm, between 50 μm and 150 μm, between 100 μm and 200 μm, between 150 μm and 250 μm, between 200 μm and 300 μm, between 250 μm and 350 μm, between 300 μm and 400 μm, between 350 μm and 450 μm, between 400 μm and 500 μm, between 450 μm and 550 μm, between 500 μm and 600 μm, between 550 μm and 650 μm, between 600 μm and 700 μm, between 650 μm and 750 μm, between 700 μm and 800 μm, between 750

μm and 850 μm, between 800 μm and 900 μm, between 850 μm and 950 μm, between 900 μm and 1000 μm, between 1 μm and 50 μm, between 10 μm and 60 μm, between 20 μm and 70 μm, between 30 μm and 80 μm, between 40 μm and 90 μm, between 90 μm and 100 μm, between 1 μm and 20 μm, between 10 μm and 30 μm, between 20 μm and 40 μm, or between 30 μm and 50 μm. In some embodiments, the depth of the through-hole 310 is approximately 1 μηι, approximately 2 μηι, approximately 3 μm, approximately 4 μm, approximately 5 μm, approximately 6 μm, approximately 7 μm, approximately 8 μm, approximately 9 μm, approximately 10 μm, approximately 20 μm, approximately 30 μm, approximately 40 μm, approximately 50 μm, approximately 60 μm, approximately 70 μm, approximately 80 μm, approximately 90 μm, approximately 100 μm, approximately 200 μm, approximately 300 μm, approximately 400 μm, approximately 500 μm, approximately 600 μm, approximately 700 μm, approximately 800 μm, approximately 900 μm, or approximately 1 mm. In some embodiments, the depth of the through-hole 310 is defined by a thickness of a portion of the casing 308 positioned around the through-hole 310. In some embodiments, a portion of the casing 308, around the through-hole 310, is indented or embossed so that the through-hole 310 has a depth that is different from the thickness of a portion of the casing 308 located away from the through-hole 310. In some embodiments, a plurality of through-holes 310 defined in the casing 308 have the same diameter. In some embodiments, a plurality of through-holes 310 defined in the casing 308 have distinct diameters (e.g., each through-hole of a first group of through-holes have a first diameter and each through-hole of a second group of through-holes have a second diameter that is different from the first diameter). In some embodiments, a plurality of through-holes 310 defined in the casing 308 have the same depth. In some embodiments, a plurality of through-holes 310 defined in the casing 308 have distinct depths (e.g., each through-hole of a first group of through-holes have a first depth and each through-hole of a second group of through-holes have a second depth that is different from the first depth).

Figure 3B further illustrates that the cantilever 302 is immobilized to a base 306 by using a clamp 304, which corresponds to the clamp 104 in Figure 1.

Although the sensor device 300 includes one or more electrodes and wiring for transmitting electrical signals from a piezoelectric material in the cantilever 302, such electrodes and wiring are omitted in Figures 3A and 3B so as not to obscure other aspects of the sensor device 300.

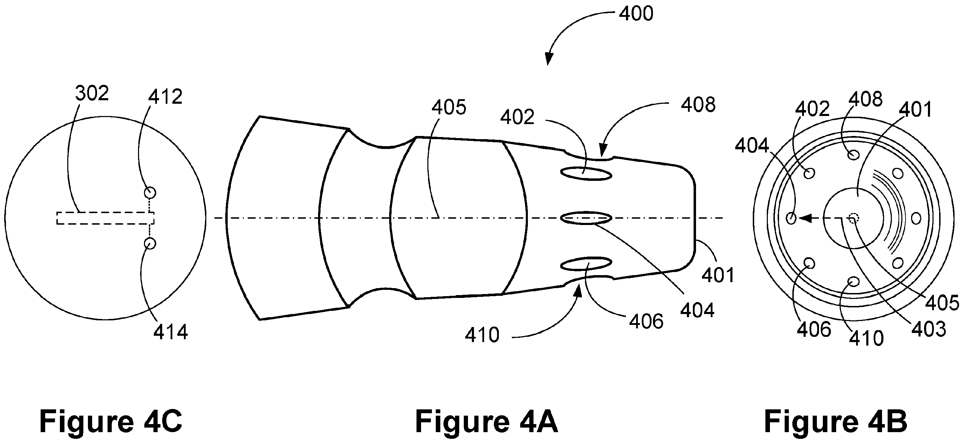

Figures 4A-4C are schematic diagrams illustrating a casing 400 in accordance with some embodiments. Figure 4A is a side elevation view of the casing 400, Figure 4B is a front elevation view, and Figure 4C is a rear elevation view. In some embodiments, the casing 400 has an asymmetric shape, and the top view and the bottom view are omitted herein for brevity.

A plurality of through-holes (e.g., through-holes 402, 404, 406, 408, and 410) are defined in the casing 400. In some embodiments, the plurality of through-holes are arranged radially around a nose area 401 of the casing 400. One of the one or more through-holes (e.g., through-hole 404) defines a reference axis 403 (e.g., an axis that extends from a center of the nose area 401, or a symmetry axis 405 of the casing 400, toward the through-hole 404), and one or more through-holes (e.g., through-holes 402 and 406) are positioned in a direction that is neither parallel nor perpendicular to the reference axis 403 from the center of the nose area 401 or the symmetry axis 405 of the casing 400. This configuration allows particles to enter the casing 400 from multiple directions (e.g., from the side of the casing 400), which improves sampling of particles depending on the orientation of the sensor device relative to the direction of an air flow around the sensor device. In some embodiments, the casing 400 is used in place of the casing 308 shown in Figures 3A and 3B.

Figure 4C also shows that electrodes (or electrical connectors) 412 and 414 positioned on the casing 400. The electrodes 412 and 414 are electrically connected to a cantilever 302 located within the casing 400 (e.g., the electrode 412 is electrically connected to a top surface of a piezoelectric material in the cantilever 302 and the electrode 414 is electrically connected to a bottom surface of the piezoelectric material in the cantilever 302) so that the vibration frequency of the cantilever 302 can be measured using a circuit located outside the casing 400.

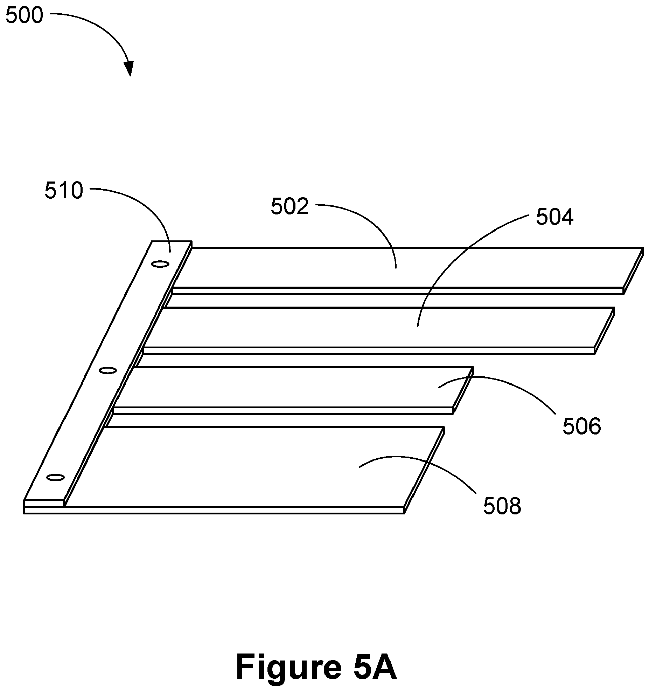

Figure 5A is a schematic diagram illustrating a cantilever device 500 with a plurality of cantilevers in accordance with some embodiments. In Figure 5A, the cantilever device 500 includes cantilevers 502, 504, 506, and 508. Figure 5A also illustrates a clamp 510, which is similar to the clamp 104 shown in Figure 1. In some embodiments, the plurality of cantilevers is immobilized with a single clamp, such as the clamp 510. In some embodiments, the plurality of cantilevers is immobilized with a plurality of clamps.

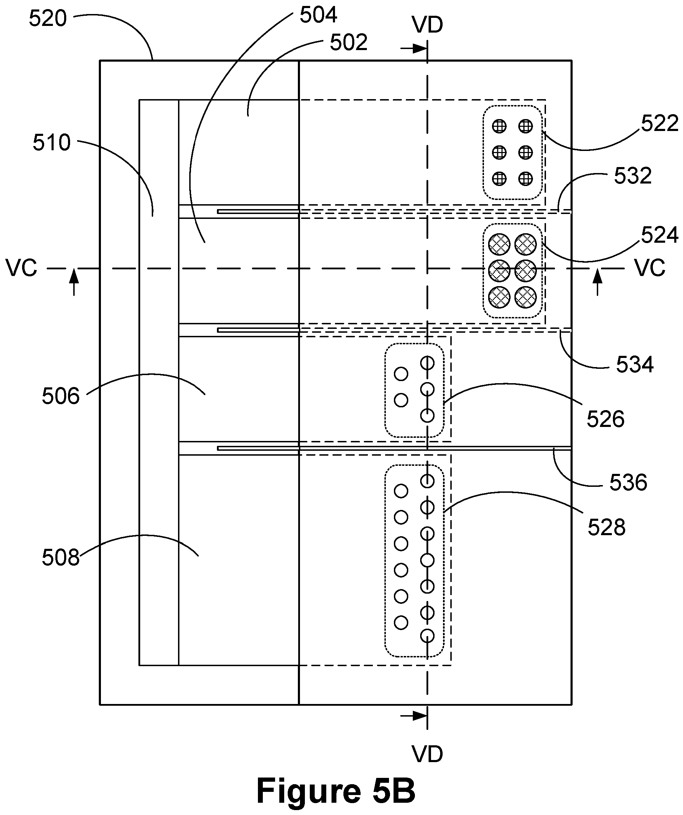

In some embodiments, the plurality of cantilevers includes a cantilever having a first length and a cantilever having a second length that is distinct from the first length (e.g., cantilevers 504 and 506). In some embodiments, the plurality of cantilevers includes a cantilever having a first width and a cantilever having a second width that is distinct from the first width (e.g., cantilevers 506 and 508). Cantilevers of different lengths and/or different widths may be used to provide different sensor characteristics (e.g., resonant frequencies, sensitivities, etc.) in detecting particles. In some embodiments, the plurality of cantilevers includes two or more cantilevers of the same length and the same width (e.g., cantilevers 502 and 504. Cantilevers of the same length and the same width may be used for duplicate measurements, which are used to reduce measurement errors and/or to increase the lifetime of a sensor device (e.g., the sensor device can continue to perform measurements even if one cantilever fails). In some cases, cantilevers of the same length and the same width have different coatings (e.g., for detecting different types of particles and/or to provide different adsorption rates). In some cases, cantilevers of the same length and the same width are positioned adjacent to through-holes of different sizes, as shown in Figure 5B.

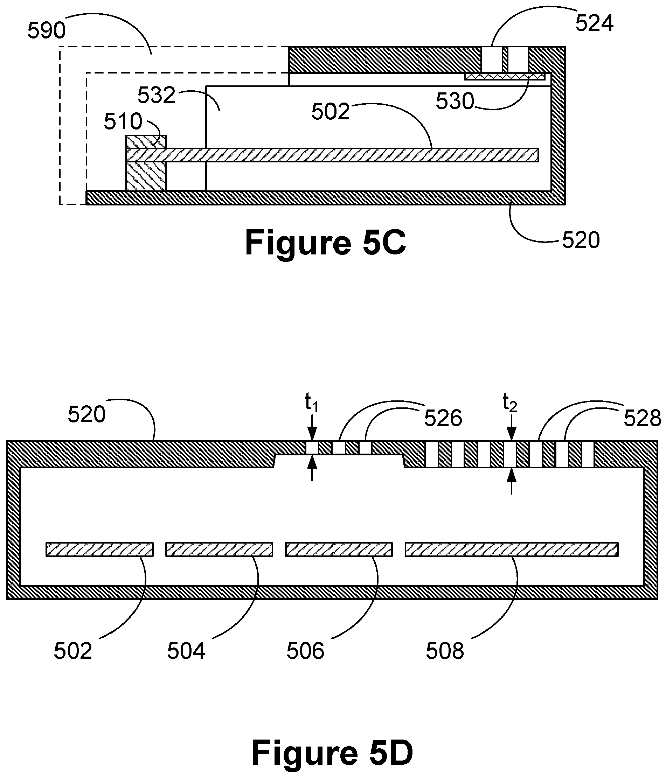

Figures 5B-5D illustrate a sensor device with the plurality of cantilevers (shown in Figure 5A) in accordance with some embodiments. Figure 5B is a plan view with line VC-VC, which represents the view from which the cross-sectional view shown in Figure 5C is taken, and line VD-VD, which represents the view from which the cross-sectional view shown in Figure 5D is taken.

The sensor device includes a casing 520, which partially encloses the plurality of cantilevers. A plurality of through-holes (e.g., through-holes 522, 524, 526, and 528) is defined in the casing 520 so that particles can enter the casing 520 through the plurality of through-holes (for subsequent adsorption on the cantilevers).

In some embodiments, through-holes of different sizes (e.g., different diameters and/or different depths) are defined in the casing 520. In Figure 5B, a first group of through-holes 522 is defined in a first region of the casing 520 (for the cantilever 502), a second group of through-holes 524 is defined in a second region of the casing 520 (for the cantilever 504) that does not overlap with the first region, a third group of through-holes 526 is defined in a third region of the casing 520 (for the cantilever 506) that does not overlap with the first region and the second region, and a fourth group of through-holes 528 is defined in a fourth region of the casing 520 (for the cantilever 508) that does not overlap with the first region, the second region, and the third region. In some embodiments, the first group of through-holes 522 have a first size (e.g., each through-hole 522 has a first diameter and a first depth) and the second group of through-holes 524 have a second size (e.g., each through-hole 524 has a second diameter and a second depth, where the second diameter is different from the first diameter and/or the second depth is different from the first depth). In some embodiments, the third group of through-holes 526 have a third size (e.g., each through-hole 526 has a third diameter and a third depth, where the third diameter may be the same as, or different from, the first diameter or the second diameter, and the third depth may be the same as, or different from, the first depth or the second depth) and the fourth group of through-holes 528 have a fourth size (e.g., each through-hole 528 has a fourth diameter and a fourth depth, where the fourth diameter may be the same as, or different from, the first diameter, the second diameter, or the third diameter, and the fourth depth may be the same as, or different from, the first depth, the second depth, or the third depth). In some embodiments, the first group of through-holes 522 has a first number of through-holes, the second group of through-holes 524 has a second number of through-holes, the third group of through-holes 526 has a third number of through-holes, and the fourth group of through-holes 528 has a fourth number of through-holes. In some embodiments, the first number, the second number, the third number, and the fourth number are the same. In some embodiments, at least two of the first number, the second number, the third number, and the fourth number are different.

In some embodiments, the sensor device includes one or more baffles (e.g., baffles 532, 534, and 536). The one or more baffles restrain the air flow (and the flow of particles carried by the air) so that particles entering the casing 520 through particular through-holes are delivered to a specific cantilever (e.g., the baffle 532 restricts movement of particles passing through the through-holes 522 primarily to the cantilever 502 and reduces movement of the particles passing through the through-holes 522 to any other cantilevers 504, 506, and 508).

In some embodiments, at least a portion of the plurality of cantilevers is exposed from the casing 520 (e.g., at least a portion of the plurality of cantilevers is visible from the outside of the casing 520), as shown in Figures 5B and 5C, when the sensor device is not mounted. However, when the sensor device is mounted, one or more portions of another component 590 (e.g., a component to which the sensor device is mounted) in conjunction with the casing 520 may fully enclose the plurality of cantilevers (except for the through-holes defined in the casing 520) so that particles may enter the casing 520 only through the through-holes defined in the casing 520.

In some embodiments, the sensor device includes a mesh 530 positioned adjacent to a top surface of the cantilever 502. A plurality of holes is defined the mesh 530 so that only particles of a certain size range (e.g., particles smaller than the holes in the mesh 530) can pass through the mesh 530. In some embodiments, the mesh 530 is sized and positioned to cover a plurality of through-holes as shown in Figure 5C. In some embodiments, the mesh 530 is sized and positioned to cover a single through-hole (which may be a large through-hole having a characteristic length, such as a diameter or a width, greater than 1 mm, 2 mm, 3 mm, 4 mm, 5 mm, 6 mm, 7 mm, 8 mm, 9 mm, or 10 mm, or a small through-hole having a characteristic length, such as a diameter or a width, less than 1 mm, 900 $\mu$m, 800 $\mu$m, 700 $\mu$m, 600 $\mu$m, 500 $\mu$m, 400 $\mu$m, 300 $\mu$m, 200 $\mu$m, or 100 $\mu$m).

Figure 5D illustrates that through-holes 526 have a first depth, $t_1$, and through-holes 528 have a second depth, $t_2$, that is different from the first depth. In some embodiments, a depth of a particular through-hole is defined by a thickness of a portion of the casing 520 adjacent to (e.g., around) the particular through-hole. For example, in some embodiments, a portion of the casing 520, around the through-holes 526, is indented as shown in Figure 5D so that the through-holes 526 have a depth that is less than the depth of the through-holes 528. Alternatively, a portion of the casing 520, around the through-holes 528, may be embossed so that the through-holes 528 have a depth that is greater than the depth of the through-holes 526.

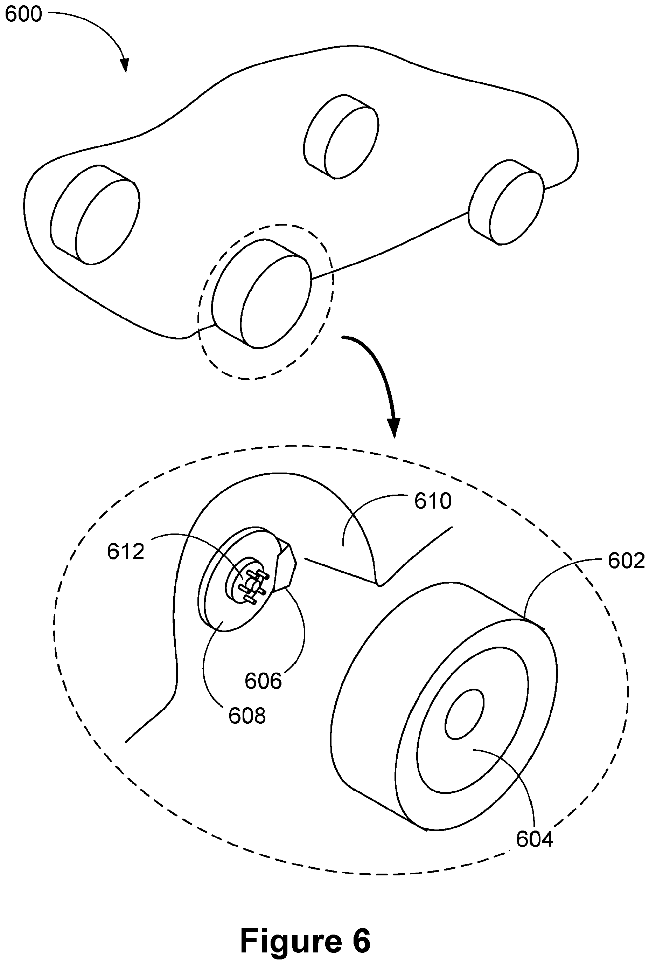

Figure 6 is a schematic diagram illustrating parts of an automobile in accordance with some embodiments. In some embodiments, the sensor devices described herein (e.g., the sensor device 300) is mounted adjacent to a wheel 604 of the automobile. Because the wheel 604 is coupled with a tire 602 and typically located adjacent to a brake (e.g., a combination of a disc 608 and a caliper 606), mounting the sensor devices adjacent to the wheel 604 facilitates collection of particles of interest (e.g., tire wear particles and brake wear particles, etc.). In some embodiments, one or more sensor devices are mounted to a fixed frame adjacent to the wheel. For example, one or more sensor devices may be mounted to a body of the automobile (e.g., around a fender, such as a location within a wheel well 610). In another example, one or more sensor devices may be mounted to the caliper 606 or any other fixed (e.g., non-rotating) part of the automobile. In some embodiments, one or more sensor devices are mounted to a rotating frame of the wheel 604 (e.g., around spokes or center disk of the wheel 604) or any other rotating part of the automobile (e.g., a hub 612 to which the wheel 604 is mounted).

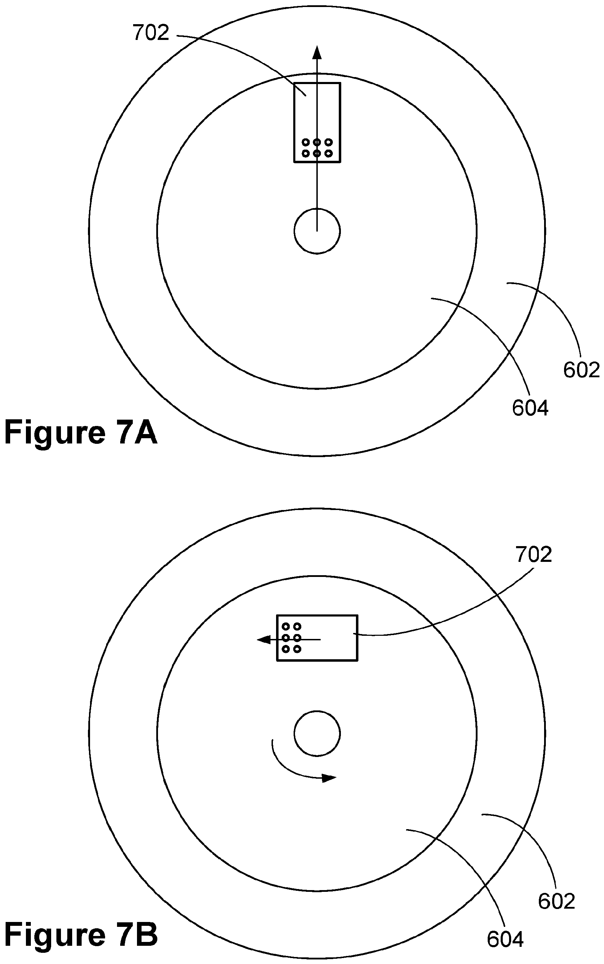

Figures 7A-7D illustrate mounting locations and orientations of a sensor device in accordance with some embodiments.

Figures 7A and 7B illustrate that a sensor assembly 702 (that includes any of the sensor devices described herein and an electrical circuit for measuring a resonance frequency of a cantilever in the sensor device, such as the electrical circuit 820) is mounted on a rotating frame of the wheel 604 (e.g., directly on the wheel 604 or another rotating component coupled to the wheel 604, such as the hub 612 shown in Figure 6). In Figure 7A, the sensor assembly 702 (in particular, the sensor device in the sensor assembly 702) is oriented so that the through-holes of the sensor assembly 702 face substantially toward a center of the wheel 604. This configuration facilitates sampling of particles from a center region of the wheel 604 that are transported radially by centrifugal force. In Figure 7B, the sensor assembly 702 (in particular, the sensor device in the sensor assembly 702) is oriented so that the through-holes of the sensor assembly 702 face a tangential direction (e.g., perpendicular to the radial direction). This configuration facilitates sampling of particles that enter the casing of the sensor assembly 702 due to the rotational velocity of the sensor assembly 702.

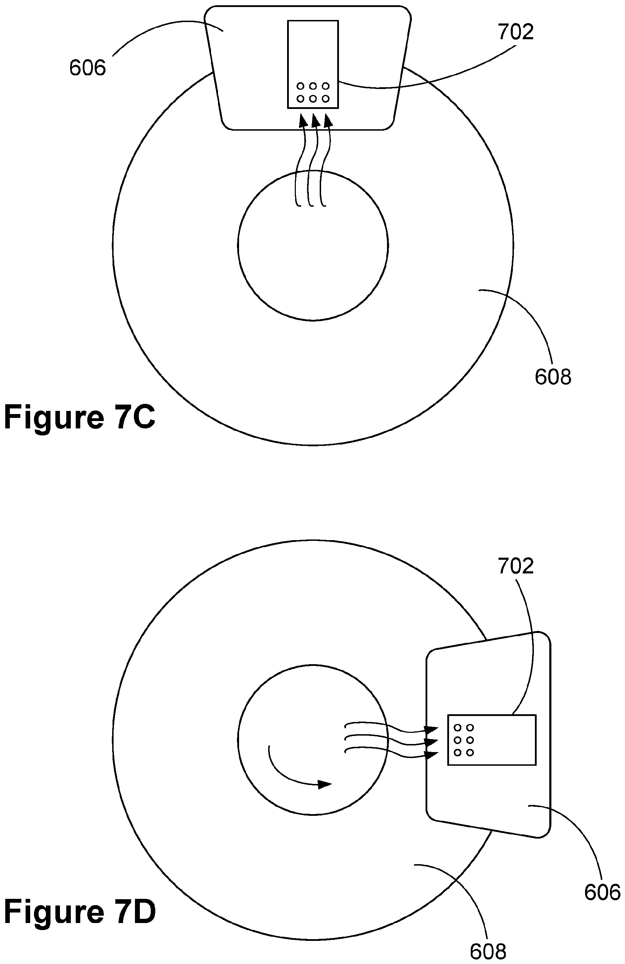

Figures 7C and 7D illustrate that the sensor assembly 702 is mounted on a fixed frame adjacent to the wheel 604 (e.g., on a body of the automobile, such as a location within a wheel well 610, or any other component adjacent to the wheel 604, such as the caliper 606 adjacent to the disc 608). In Figure 7C, the sensor assembly 702 (in particular, the sensor device in the sensor assembly 702) is positioned adjacent to an upper half of the wheel (or the disc 608) with its through-holes facing substantially downward (e.g., toward the center of the wheel). This configuration facilitates sampling of particles that are transported by convection. For example, thermal gradient generated by parts around the wheel 604 induces convective flow of air, carrying particles upward, and the sensor device with through-holes facing downward can detect particles carried by the convective flow. In Figure 7D, the sensor assembly 702 (in particular, the sensor device in the sensor assembly 702) is positioned adjacent to a rear half of the wheel (or the disc 608). This configuration facilitates sampling of particles that are transported by airflow generated while the automobile is moving.

Although Figures 7A-7D illustrate example configurations for mounting the sensor assembly 702, the sensor assembly 702 (in particular, the sensor device in the sensor assembly 702) may be positioned in other locations and/or other orientations. For example, the sensor assembly 702 may be oriented obliquely.

Figures 8A-8C illustrate structures of example cantilevers in accordance with some embodiments.

Figure 8A shows a cantilever with a layer 802 of piezoelectric material located between electrodes 804 and 806 (while electrodes 804 and 806 are in contact with the layer 802 of piezoelectric material). When the cantilever bends, the layer 802 of piezoelectric material provides charges that are indicative of the amplitude of how much the cantilever is bent (e.g., a displacement of a free end of the cantilever). The amount of charges is measured by an electrical circuit 820, which is capable of determining a resonance frequency of the cantilever. In some embodiments, the electrical circuit 820 is electrically coupled to the layer 802 of piezoelectric material through electrodes (e.g., electrodes 412 and 414 shown in Figure 4C).

However, a cantilever may include two or more layers of piezoelectric material. Figure 8B shows a cantilever with layers 802 and 808 of piezoelectric materials with an electrode 810 located in-between. The layer 802 of a piezoelectric material is in contact with the electrode 804 and the layer 808 of a piezoelectric material is in contact with the electrode 806. The amount of charges generated by the layers 802 and 808 of piezoelectric material is measured by the electrical circuit 820. In some embodiments, the piezoelectric material in the layer 802 and the piezoelectric material in the layer 808 are the same. In some embodiments, the piezoelectric material in the layer 802 and the piezoelectric material in the layer 808 are different.

In some cases, a layer 802 of piezoelectric material need not extend along an entire length of a cantilever. Figure 8C shows a cantilever in which the layer 802 of piezoelectric material extends partially within the cantilever. In some embodiments, the cantilever includes a layer 812 of elastic material.

Although Figures 8A-8C illustrate example configurations of a cantilever that includes a piezoelectric material, other configurations of a cantilever that includes a piezoelectric material may be used. For example, the cantilever may include one or more layers of material other than a piezoelectric material or an electrode material (e.g., when a sensor device includes a plurality of cantilevers as shown in Figure 5B, one or more cantilevers of the plurality of cantilevers may include a layer of a low elasticity (high stiffness) material, such as steel. The layer of the low elasticity material reduces the bending of the cantilever and increases the dynamic range of measurements (e.g., a cantilever with the layer of the low elasticity material may detect a larger quantity of particles). In some embodiments, each of two or more cantilevers includes a layer of a low elasticity material, but the thickness of the layer of the low elasticity material is different between the two or more cantilevers.

In addition, although Figures 8A-8C illustrate that the electrical circuit 820 is coupled with a single cantilever. However, in some embodiments, the electrical circuit 820 may be coupled with a plurality of cantilevers (e.g., using a switch to relay electrical signal from one cantilever to the electrical circuit 820 at a time).

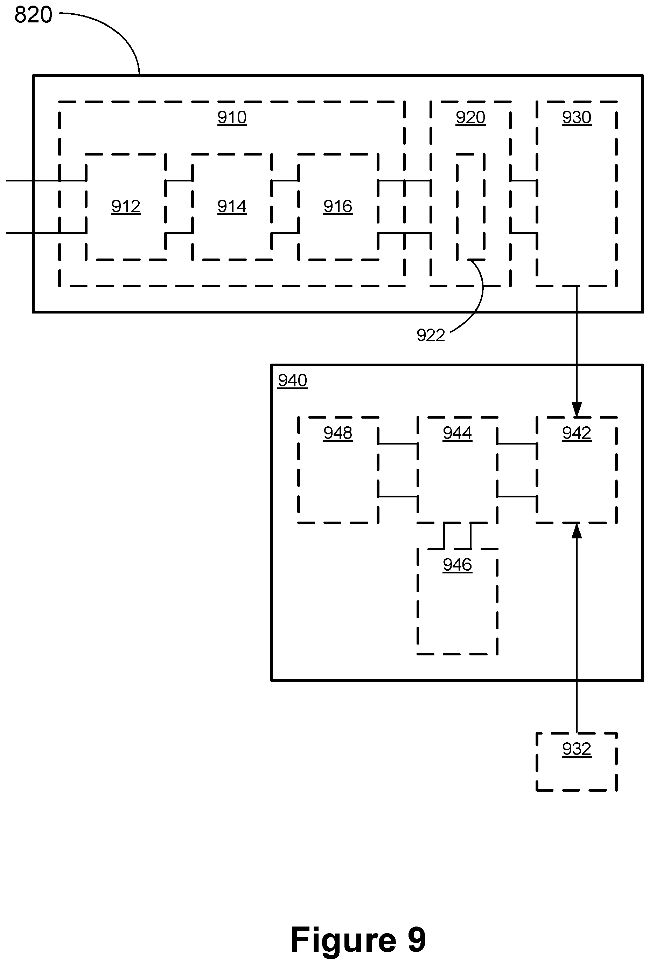

Figure 9 is a schematic diagram illustrating an electrical circuit 820 for measuring a frequency of a signal in accordance with some embodiments.

In some embodiments, electrical circuit 820 includes an input circuit 910, a counter circuit 920, and an output circuit 930.

In some embodiments, the input circuit 910 includes one or more of the following:

- a pre-filter 912 (e.g., a circuit including a capacitor), which reduces noise in the received electrical signal;
- a squarization circuit 914 (e.g., a comparator, such as a Schmitt trigger), which converts a sinusoidal signal to a square wave signal; and
- an amplitude stabilizer 916, which stabilizes an amplitude of the square wave signal.

The counter circuit 920 counts the frequency of the square wave signal. In some embodiments, the counter circuit 920 includes a clock 922 so that the counter circuit 920 can measure a number of square waves within a particular time period (and/or reset the counter circuit 920 at a particular time interval).

The output circuit 930 is configured to provide the frequency information (e.g., to another circuit, such as electrical circuit 940). In some embodiments, the output circuit 930 is configured to provide the frequency information via wired communication. In some embodiments, the output circuit 930 is configured to provide the frequency information via wireless communication, such as Bluetooth, Zigbee, Wi-Fi, etc.

The electrical circuit 940 is configured for determining a quantity of particles based on the frequency information from the electrical circuit 820. In some embodiments, the electrical circuit 940 includes an input circuit 942, which receives the frequency information from the electrical circuit 820 via wired or wireless communication. The electrical circuit 940 includes one or more processors 944 (e.g., microprocessors, central processing units (CPUs), accelerated processing units (APU), etc.). In some embodiments, the one or more processors 944 are coupled with memory 946, which stores instructions and/or data (e.g., a lookup table corresponding to the curve 210) for converting the frequency information to a quantity of particles. In some embodiments, the one or more processors 944 store the determined quantities in memory 946. In some embodiments, the memory 946 includes high-speed random access memory, such as DRAM, SRAM, DDR RAM or other random access solid state memory devices; and may include non-volatile memory, such as flash memory devices, or other non-volatile solid state storage devices.

In some embodiments, the electrical circuit 940 includes an output circuit 948, which is configured for outputting the quantity information (e.g., to a separate scanner or to the on-board computer of the automobile).

In some embodiments, the input circuit 942 receives temperature information from temperature sensor 932. In some embodiments, the temperature sensor 932 is located adjacent to a cantilever (e.g., within the casing that at least partially encloses the cantilever, such as the casing 308 in Figure 3B). This allows the temperature sensor 932 to provide temperature information associated with the cantilever. In some embodiments, the temperature sensor 932 is integrated with the cantilever. In some embodiments, the one or more processors 944 determine the quantity of particles based on the frequency information and the temperature information (e.g., using a predetermined calibration curve or a lookup table). In some embodiments, the one or more processors 944 determines the quantity of particles based on the frequency information independently of the temperature information and adjusts the quantity of particles based on the temperature information (e.g., using a predetermined calibration curve or a lookup table). In some embodiments, separate electrical circuit that modifies electrical signals representing the frequency information based on the temperature information is included in the electrical circuit 820 or 940.

Although Figure 9 illustrates one example of the electrical circuit 820, other electrical circuits may be used to determine a frequency of an electrical signal. For example, the electrical circuit 820 may include an analog-to-digital converter coupled with a frequency counter. In another example, the electrical circuit 820 may include a zero crossing detector instead of a comparator. In some embodiments, the electrical circuit 820 may include resonant circuits having distinct resonant frequencies.

In addition, although Figure 9 illustrates the electrical circuit 820 and the electrical circuit 940 that determine the quantity of the particles based on the frequency information, in some embodiments, the electrical circuit 820 and the electrical circuit 940 determine the quantity of the particles based on other electrical signals (which may or may not be associated with the resonance frequency of the cantilever), such as peak-to-peak voltages from a piezoelectrical cantilever.

Furthermore, although Figure 9 illustrates the electrical circuit 820 and the electrical circuit 940 as separate circuits, in some embodiments, the electrical circuit 820 and the electrical circuit 940 are integrated. In some embodiments, the electrical circuit 820 is separated, and located remotely, from the electrical circuit 940.

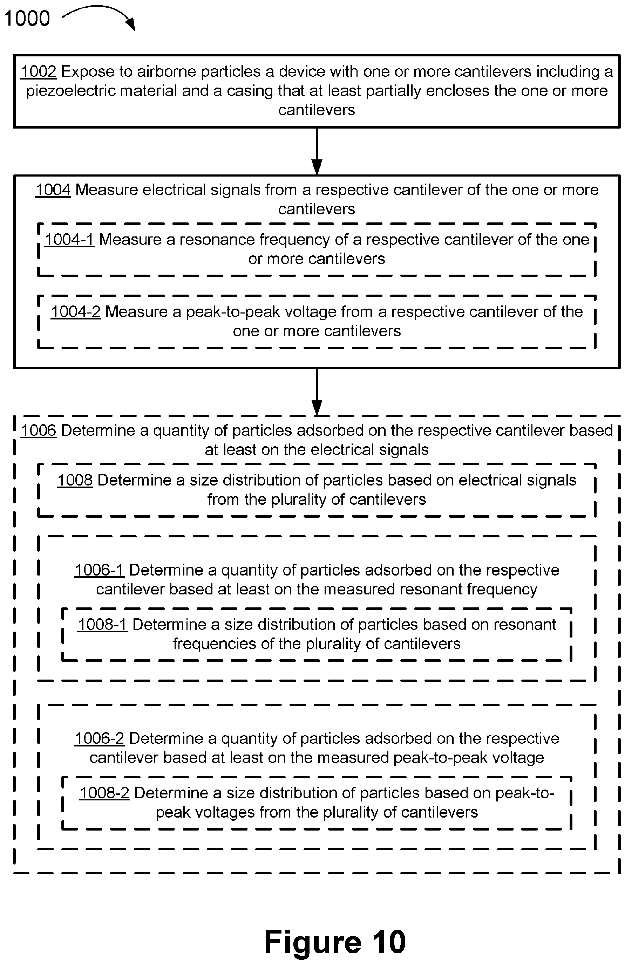

Figure 10 is a flow diagram illustrating a method 1000 of detecting particles in accordance with some embodiments.

Method 1000 includes (1002) exposing any device described herein to airborne particles. For example, any sensor device described herein is mounted to an automobile adjacent to a wheel.

Method 1000 also includes (1004) measuring (or determining) electrical signals from a respective cantilever of the one or more cantilevers. In some embodiments, method 1000 includes (1004-1) measuring (or determining) a resonance frequency of the respective cantilever of the one or more cantilevers. For example, a resonance frequency of a cantilever is measured using an electrical circuit (e.g., the electrical circuit 820) as described above with respect to Figure 9. In some embodiments, method 1000 includes (1004-2) measuring (or determining) a peak-to-peak voltage from the respective cantilever of the one or more cantilevers.

In some embodiments, method 1000 includes (1006) determining a quantity of particles adsorbed on the respective cantilever based at least on the electrical signals (e.g., using the electrical circuit 940).

In some embodiments, method 1000 includes (1006-1) determining a quantity of particles adsorbed on the respective cantilever based at least on the measured resonance frequency (e.g., using the electrical circuit 940).

In some embodiments, the quantity of particles adsorbed on the respective cantilever is determined based on a shift in the measured resonance frequency from one or more prior resonant frequencies of the respective cantilever.

In some embodiments, method 1000 includes (1006-2) determining a quantity of particles adsorbed on the respective cantilever based at least on the measured peak-to-peak voltage (e.g., using the electrical circuit 940).

In some embodiments, the device includes a plurality of cantilevers (e.g., Figure 5A). Method 1000 includes (1008) determining a size distribution of particles based on electrical signals from the plurality of cantilevers. In some embodiments, method 1000 includes (1008-1) determining a size distribution of particles based on resonant frequencies of the plurality of cantilevers (e.g., Figure 2C). In some embodiments, method 1000 includes (1008-2) determining a size distribution of particles based on peak-to-peak voltages from the plurality of cantilevers.

In some embodiments, the plurality of cantilevers is different from one another. In some embodiments, the plurality of cantilevers is coupled with through-holes that are different from one another. In some embodiments, the plurality of cantilevers is coupled with meshes that are different from one another.

In some embodiments, the device is mounted adjacent to a wheel and the airborne particles are emitted from a brake of the wheel or a tire of the wheel (e.g., Figure 6).

In light of these principles and examples, we now turn to certain embodiments.

In accordance with some embodiments, a device (e.g., the sensor device 300) includes one or more cantilevers (e.g., the cantilever 302) and a casing (e.g., the casing 308) that at least partially encloses the one or more cantilevers. One or more through-holes (e.g., the through-holes 310) are defined in the casing.

In some embodiments, the one or more cantilevers include a piezoelectric material (e.g., the layer 802 of a piezoelectric material). In some embodiments, the one or more cantilevers are coupled with one or more strain gauges. The piezoelectric material and/or the one or more strain gauges may be used to measure a resonant frequency of a respective cantilever.

In some embodiments, the one or more through-holes are configured to allow airborne particles to enter the casing through the one or more through-holes and interact with the one or more cantilevers (e.g., in Figure 3B, the particles 320 are allowed to pass through the one or more through-holes 310).

In some embodiments, the one or more through-holes are positioned adjacent to free ends of the one or more cantilevers (e.g., in Figure 3B, the one or more through-holes 310 are positioned adjacent to a free end of the cantilever 302).

In some embodiments, a plurality of through-holes is defined in the casing; and the plurality of through-holes includes a first through-hole having a first diameter and a second through-hole having a second diameter different from the first diameter (e.g., in Figure 5B, the through-holes 522 of a first diameter and the through-holes 524 of a second diameter different from the first diameter are defined in the casing 520).

In some embodiments, a plurality of through-holes is defined in the casing, and the plurality of through-holes includes a first through-hole having a first depth and a second through-hole having a second depth different from the first depth (e.g., in Figure 5D, the through-holes 526 have a first depth $t_1$, and through-holes 528 have a second depth $t_2$ that is different from the first depth).

In some embodiments, a plurality of through-holes is defined in the casing; and the plurality of through-holes includes a first through-hole oriented in a first direction and a second through-hole oriented in a second direction different from the first direction (e.g., in Figures 4A and 4B, the through-hole 408 is oriented substantially upward whereas the through-hole 404 is oriented substantially sideways).

In some embodiments, the device further includes a mesh with a plurality of holes (e.g., the mesh 530 in Figure 5C), the mesh being positioned adjacent to a top surface of a respective cantilever of the one or more cantilevers.

In some embodiments, the one or more cantilevers include a first cantilever and a second cantilever that is distinct from the first cantilever (e.g., any combination of the cantilevers 502, 504, 506, and 508 in Figure 5A).

In some embodiments, the first cantilever has a first length and the second cantilever has a second length that is different from the first length (e.g., in Figure 5A, the cantilever 504 has a first length and the cantilever 506 has a second length that is different from the first length). In some embodiments, the first cantilever and the second cantilever have a same length.

In some embodiments, the first cantilever has a first width and the second cantilever has a second width that is different from the first width (e.g., in Figure 5A, the cantilever 506 has a first width and the second cantilever 508 has a second width that is different from the first width). In some embodiments, the first cantilever and the second cantilever have a same width.

In some embodiments, the first cantilever has a first surface area and the second cantilever has a second surface area that is different from the first surface area (e.g., in Figure 5A, the cantilever 506 has a first surface area and the cantilever 508 has a second surface area that is different from the first surface area). In some embodiments, the first cantilever and the second cantilever have a same surface area.

In some embodiments, the first cantilever has a first thickness and the second cantilever has a second thickness that is different from the first thickness. In some embodiments, the first cantilever and the second cantilever have a same thickness.

In some embodiments, the device further includes a first electrical circuit coupled with a respective cantilever of the one or more cantilevers to measure a resonance frequency of the respective cantilever (e.g., the electrical circuit 820).

In some embodiments, the device further includes a second electrical circuit coupled with the first electrical circuit to determine a quantity of particles adsorbed on the respective cantilever based at least on the measured resonance frequency (e.g., the electrical circuit 940).

In accordance with some embodiments, a sensor assembly mountable adjacent to a wheel includes a device that includes one or more cantilevers including a piezoelectric material and a casing that at least partially encloses the one or more cantilevers (e.g., the sensor device 300). One or more through-holes are defined in the casing. The sensor assembly also includes an electrical circuit coupled with a respective cantilever of the one or more cantilevers to measure a resonance frequency of the respective cantilever (e.g., the electrical circuit 820).

In some embodiments, the sensor assembly is configured for mounting to a rotating frame of the wheel; and the device is oriented on the sensor assembly to allow airborne particles to enter the casing through the one or more through-holes while the device rotates with the wheel (e.g., Figures 7A and 7B).

In some embodiments, the sensor assembly is configured for mounting to a fixed frame adjacent to the wheel; and the device is oriented on the sensor assembly to allow airborne particles to enter the casing through the one or more through-holes while the wheel rotates adjacent to the device (e.g., Figures 7C and 7D).

Some embodiments may be described with respect to the following clauses:

Clause 1. A sensor assembly mountable adjacent to a wheel, the sensor assembly comprising:

a device that includes:

one or more cantilevers; and
a casing that at least partially encloses the one or more cantilevers, wherein one or more through-holes are defined in the casing; and

a first electrical circuit coupled with a respective cantilever of the one or more cantilevers to measure electrical signals from the respective cantilever.

Clause 2. The sensor assembly of clause 1, wherein:

the sensor assembly is configured for mounting to a rotating frame of the wheel; and
the device is oriented on the sensor assembly to allow airborne particles to enter the casing through the one or more through-holes while the device rotates with the wheel. Clause 3. The sensor assembly of clause 1, wherein:
the sensor assembly is configured for mounting to a fixed frame adjacent to the wheel; and
the device is oriented on the sensor assembly to allow airborne particles to enter the casing through the one or more through-holes while the wheel rotates adjacent to the device.

Clause 4. The sensor assembly of any of clauses 1-3, wherein:
the first electrical circuit includes a circuit for measuring a resonance frequency of the respective cantilever.
Clause 5. The sensor assembly of any of clauses 1-3, wherein:

the first electrical circuit includes a circuit for measuring a peak-to-peak voltage from the respective cantilever.
Clause 6. The sensor assembly of any of clauses 1-5, further comprising:
a second electrical circuit coupled with the first electrical circuit to determine a quantity of particles adsorbed on the respective cantilever based at least on the measured electrical signals.
Clause 7. The sensor assembly of any of clauses 1-5, further comprising:
a temperature sensor for providing temperature information associated with at least the respective cantilever.
Clause 8. The sensor assembly of clause 7, further comprising:
a second electrical circuit coupled with the first electrical circuit to determine a quantity of particles adsorbed on the respective cantilever based at least on the measured electrical signals and the temperature information from the temperature sensor.
Clause 9. A device, comprising:

one or more cantilevers; and
a casing that at least partially encloses the one or more cantilevers, wherein one or more through-holes are defined in the casing.

Clause 10. The device of clause 9, wherein the one or more through-holes are configured to allow airborne particles to enter the casing through the one or more through-holes and interact with the one or more cantilevers.
Clause 11. The device of clause 9 or 10, wherein the one or more through-holes are positioned adjacent to free ends of the one or more cantilevers.
Clause 12. The device of any of clauses 9-11, wherein:
a plurality of through-holes is defined in the casing, including a first through-hole and a second through-hole.
Clause 13. The device of clause 12, wherein:
the first through-hole has a first diameter and the second through-hole has a second diameter different from the first diameter.
Clause 14. The device of clause 12 or 13, wherein:
the first through-hole has a first depth and the second through-hole has a second depth different from the first depth.
Clause 15. The device of any of clauses 12-14, wherein:
the first through-hole is oriented in a first direction and the second through-hole is oriented in a second direction different from the first direction.
Clause 16. The device of any of clauses 9-15, further comprising:
a mesh with a plurality of holes, the mesh being positioned adjacent to a top surface of a respective cantilever of the one or more cantilevers.

Clause 17. The device of any of clauses 9-16, wherein:
the one or more cantilevers include a first cantilever and a second cantilever that is distinct from the first cantilever.

Clause 18. The device of clause 17, wherein:
the first cantilever has a first length and the second cantilever has a second length that is different from the first length.

Clause 19. The device of clause 17 or 18, wherein:
the first cantilever has a first surface area and the second cantilever has a second surface area that is different from the first surface area.

Clause 20. The device of any of clauses 9-19, further comprising:
a first electrical circuit coupled with a respective cantilever of the one or more cantilevers to measure a resonance frequency of the respective cantilever.

Clause 21. The device of clause 20, further comprising:
a second electrical circuit coupled with the first electrical circuit to determine a quantity of particles adsorbed on the respective cantilever based at least on the measured resonance frequency.

Clause 22. The device of clause 21, wherein:
the second electrical circuit is configured to determine the quantity of particles adsorbed on the respective cantilever based at least on the measured resonance frequency and temperature information associated with the respective cantilever.

Clause 23. The device of any of clauses 9-19, further comprising:
a first electrical circuit coupled with a respective cantilever of the one or more cantilevers to measure a peak-to-peak voltage from the respective cantilever.

Clause 24. The device of clause 23, further comprising:
a second electrical circuit coupled with the first electrical circuit to determine a quantity of particles adsorbed on the respective cantilever based at least on the measured peak-to-peak voltage.

Clause 25. The device of clause 24, wherein:
the second electrical circuit is configured to determine the quantity of particles adsorbed on the respective cantilever based at least on the measured peak-to-peak voltage and temperature information associated with the respective cantilever.

Clause 26. A method, comprising:

exposing the device of any of clauses 9-25 to airborne particles; and
measuring electrical signals from a respective cantilever of the one or more cantilevers.

Clause 27. The method of clause 26, wherein:
measuring the electrical signals from the respective cantilever includes measuring a resonance frequency of the respective cantilever.

Clause 28. The method of clause 27, further comprising:
determining a quantity of particles adsorbed on the respective cantilever based at least on the measured resonance frequency.

Clause 29. The method of clause 28, including:
determining the quantity of particles adsorbed on the respective cantilever based at least on the measured resonance frequency and temperature information associated with the respective cantilever.

Clause 30. The method of clause 28 or 29, wherein the quantity of particles adsorbed on the respective cantilever is determined based on a shift in the measured resonance frequency from one or more prior resonant frequencies of the respective cantilever.

Clause 31. The method of any of clauses 27-30, wherein:

the device includes a plurality of cantilevers; and
the method includes determining a size distribution of particles based on resonant frequencies of the plurality of cantilevers.

Clause 32. The method of clause 26, wherein:
measuring the electrical signals from the respective cantilever includes measuring a peak-to-peak voltage from the respective cantilever.

Clause 33. The method of clause 32, further comprising:
determining a quantity of particles adsorbed on the respective cantilever based at least on the measured peak-to-peak voltage.

Clause 34. The method of clause 33, including:
determining the quantity of particles adsorbed on the respective cantilever based at least on the measured peak-to-peak voltage and temperature information associated with the respective cantilever.

Clause 35. The method of clause 32 or 33, wherein the quantity of particles adsorbed on the respective cantilever is determined based on a change in the measured peak-to-peak voltage from one or more prior peak-to-peak voltages from the respective cantilever.

Clause 36. The method of any of clauses 32-35, wherein:

the device includes a plurality of cantilevers; and
the method includes determining a size distribution of particles based on peak-to-peak voltages from the plurality of cantilevers.

Clause 37. The method of any of clauses 26-36, wherein the device is mounted adjacent to a wheel and the airborne particles are emitted from a brake of the wheel or a tire of the wheel.

Clause 38. A sensor assembly mountable adjacent to a wheel, the sensor assembly comprising:

the device of any of clauses 9-25; and
an electrical circuit coupled with a respective cantilever of the one or more cantilevers to measure electrical signals from the respective cantilever.

Clause 39. The sensor assembly of clause 38, wherein:

the sensor assembly is configured for mounting to a rotating frame of the wheel; and
the device is oriented on the sensor assembly to allow airborne particles to enter the casing through the one or more through-holes while the device rotates with the wheel. Clause 40. The sensor assembly of clause 38, wherein:
the sensor assembly is configured for mounting to a fixed frame adjacent to the wheel; and
the device is oriented on the sensor assembly to allow airborne particles to enter the casing through the one or more through-holes while the wheel rotates adjacent to the device.

The foregoing description, for purpose of explanation, has been described with reference to specific embodiments. However, the illustrative discussions above are not intended to be exhaustive or to limit the scope of claims to the precise forms disclosed. Many modifications and variations are possible in view of the above teachings. The embodiments were chosen and described in order to best explain the principles of the various described embodiments and their practical applications, to thereby enable others skilled in the art to best utilize the principles and the various described embodiments with various modifications as are suited to the particular use contemplated.

**Claims**

1. A device, comprising:

   one or more cantilevers; and
   a casing that at least partially encloses the one or more cantilevers, wherein one or more through-holes are defined in the casing.

2. The device of claim 1, wherein the one or more through-holes are configured to allow airborne particles to enter the casing through the one or more through-holes and interact with the one or more cantilevers.

3. The device of claim 1 or 2, wherein the one or more through-holes are positioned adjacent to free ends of the one or more cantilevers.

4. The device of any of claims 1-3, wherein:

the one or more through-holes include a through-hole having a first diameter and a through-hole having a second diameter different from the first diameter.

5. The device of any of claims 1-4, wherein:
the one or more through-holes include a through-hole having a first depth and a through-hole having a second depth different from the first depth.

6. The device of any of claims 1-5, wherein:
the one or more through-holes include a through-hole oriented in a first direction and a through-hole oriented in a second direction different from the first direction.

7. The device of any of claims 1-6, further comprising:
a mesh with a plurality of holes, the mesh being positioned adjacent to a top surface of a respective cantilever of the one or more cantilevers.

8. The device of any of claims 1-7, wherein:
the one or more cantilevers include a first cantilever and a second cantilever that is distinct from the first cantilever.

9. The device of claim 8, wherein:

   the first cantilever has a first length and the second cantilever has a second length that is different from the first length; or
   the first cantilever has a first surface area and the second cantilever has a second surface area that is different from the first surface area.

10. A sensor assembly mountable adjacent to a wheel, the sensor assembly comprising:

    the device of any of claims 1-9; and
    a first electrical circuit coupled with a respective cantilever of the one or more cantilevers to measure electrical signals from the respective cantilever.

11. The sensor assembly of claim 10, wherein:

    the sensor assembly is configured for mounting to a rotating frame of the wheel or a fixed frame adjacent to the wheel; and
    the device is oriented on the sensor assembly to allow airborne particles to enter the casing through the one or more through-holes while the device rotates with the wheel.

12. The sensor assembly of claim 10 or 11, wherein:
the first electrical circuit includes a circuit for measuring a resonance frequency of the respective cantilever or a peak-to-peak voltage from the respective cantilever.

13. The sensor assembly of any of claims 10-12, further comprising:
a temperature sensor for providing temperature information associated with at least the respective cantilever.

14. The sensor assembly of claim 13, further comprising:
a second electrical circuit coupled with the first electrical circuit to determine a quantity of particles adsorbed on the respective cantilever based at least on the measured electrical signals and the temperature information from the temperature sensor.

15. A method, comprising:

exposing the device of any of claims 1-9 to airborne particles; and
measuring electrical signals from a respective cantilever of the one or more cantilevers.

100

106    102    108

104

W

L

**Figure 1**

**Figure 2A**

**Figure 2B**

Amount

224 — 226

222

228

Size

**Figure 2C**

M

230

$V_{pp}$

**Figure 2D**

$V_{correction}$

T

# Figure 2E

**Figure 3A**

**Figure 3B**

**Figure 4B**

**Figure 4A**

**Figure 4C**

500

510

502

504

506

508

**Figure 5A**

**Figure 5B**

590    524

532    510    502    530    520

**Figure 5C**

520    $t_1$    526    $t_2$    528

502    504    506    508

**Figure 5D**

**Figure 6**

Figure 7A

Figure 7B

606

702

608

**Figure 7C**

702

606

608

**Figure 7D**

**Figure 8A**

**Figure 8B**

**Figure 8C**

820

910

912    914    916    920    930

922

940

948    944    942

946

932

**Figure 9**

1000

1002 Expose to airborne particles a device with one or more cantilevers including a piezoelectric material and a casing that at least partially encloses the one or more cantilevers

1004 Measure electrical signals from a respective cantilever of the one or more cantilevers

1004-1 Measure a resonance frequency of a respective cantilever of the one or more cantilevers

1004-2 Measure a peak-to-peak voltage from a respective cantilever of the one or more cantilevers

1006 Determine a quantity of particles adsorbed on the respective cantilever based at least on the electrical signals

1008 Determine a size distribution of particles based on electrical signals from the plurality of cantilevers

1006-1 Determine a quantity of particles adsorbed on the respective cantilever based at least on the measured resonant frequency

1008-1 Determine a size distribution of particles based on resonant frequencies of the plurality of cantilevers

1006-2 Determine a quantity of particles adsorbed on the respective cantilever based at least on the measured peak-to-peak voltage

1008-2 Determine a size distribution of particles based on peak-to-peak voltages from the plurality of cantilevers

# Figure 10

Europäisches
Patentamt

European
Patent Office

Office européen
des brevets

# EUROPEAN SEARCH REPORT

Application Number

EP 21 15 5639

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2008/021187 A2 (UNIV DREXEL [US]; MUTHARASAN RAJAKKANNU [US] ET AL.) 21 February 2008 (2008-02-21) * abstract; claims 1,20-23; figures 8-10,15,68,74,91,93 * * paragraphs [0039], [0040], [0052], [0058], [0077] * | 1-15 | INV. B81B3/00 G01N15/10 G01N29/02 |
| X | US 2008/035180 A1 (MUTHARASAN RAJAKKANNU [US] ET AL) 14 February 2008 (2008-02-14) * abstract; figure 4 * * paragraphs [0031], [0057], [0066] - [0070], [0080] - [0082] * | 1-15 | |
| X | US 8 524 482 B1 (WICK CHARLES H [US]) 3 September 2013 (2013-09-03) * abstract; claim 1; figure 10 * * column 7, lines 4-15 * * column 16, lines 49-50 * | 1-15 | |
| A | WO 2005/031300 A2 (PURDUE RESEARCH FOUNDATION [US]; BASHIR RASHID [US] ET AL.) 7 April 2005 (2005-04-07) * abstract; figure 1 * * page 41, lines 18-23 * | 1-15 | TECHNICAL FIELDS SEARCHED (IPC) B81B G01N B82B |
| A | WO 2015/049301 A1 (TECH UNIVERSITÄT WIEN [AT]; AC2T RES GMBH [AT]) 9 April 2015 (2015-04-09) * abstract; figures 1-5 * * page 7, lines 27-35 * | 1-15 | |

The present search report has been drawn up for all claims

| Place of search | Date of completion of the search | Examiner |
|---|---|---|
| The Hague | 13 July 2021 | Nelva-Pasqual, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 21 15 5639

This annex lists the patent family members relating to the patent documents cited in the above-mentioned European search report.
The members are as contained in the European Patent Office EDP file on
The European Patent Office is in no way liable for these particulars which are merely given for the purpose of information.

13-07-2021

| Patent document cited in search report | | Publication date | Patent family member(s) | | Publication date |
|---|---|---|---|---|---|
| WO 2008021187 | A2 | 21-02-2008 | US 2008034840 A1<br>WO 2008021187 A2 | | 14-02-2008<br>21-02-2008 |
| US 2008035180 | A1 | 14-02-2008 | US 2008035180 A1<br>WO 2008021189 A2 | | 14-02-2008<br>21-02-2008 |
| US 8524482 | B1 | 03-09-2013 | US 8524482 B1<br>US 9651462 B1 | | 03-09-2013<br>16-05-2017 |
| WO 2005031300 | A2 | 07-04-2005 | AU 2004276725 A1<br>CA 2530607 A1<br>EP 1651943 A2<br>WO 2005031300 A2 | | 07-04-2005<br>07-04-2005<br>03-05-2006<br>07-04-2005 |
| WO 2015049301 | A1 | 09-04-2015 | AT 514855 A1<br>DE 112014004564 A5<br>WO 2015049301 A1 | | 15-04-2015<br>04-08-2016<br>09-04-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62978634